Europäisches Patentamt

European Patent Office

Office européen des brevets

(19)

(11) EP 0 658 977 B1

(12)

# FASCICULE DE BREVET EUROPEEN

(45) Date de publication et mention
de la délivrance du brevet:
**16.09.1998 Bulletin 1998/38**

(51) Int Cl.⁶: **H03G 1/00**

(21) Numéro de dépôt: **94402868.7**

(22) Date de dépôt: **13.12.1994**

(54) **Amplificateur à gain variable**

Verstärker mit einstellbarer Verstärkung

Variable gain amplifier

(84) Etats contractants désignés:
**BE DE FR GB IT NL**

(30) Priorité: **17.12.1993 FR 9315228**

(43) Date de publication de la demande:
**21.06.1995 Bulletin 1995/25**

(73) Titulaire: **THOMSON-CSF SEMICONDUCTEURS
SPECIFIQUES
75008 Paris (FR)**

(72) Inventeur: **Debroux, Jean-François
F-92402 Courbevoie Cédex (FR)**

(74) Mandataire: **Guérin, Michel et al
Thomson-CSF Propriété Intellectuelle,
13, Avenue du Président Salvador Allende
94117 Arcueil Cédex (FR)**

(56) Documents cités:
**DE-A- 1 487 527          DE-A- 3 813 532
FR-A- 2 228 324**

# Description

L'invention définie par les revendications concerne un amplificateur à gain variable et plus particulièrement un étage d'entrée de chaîne d'amplification de circuit de réception tel que ceux utilisés dans les systèmes de transmission.

Les chaînes d'amplification de circuit de réception doivent présenter un ensemble de caractéristiques difficiles à concilier : le gain, variable, doit être élevé, l'impédance d'entrée doit avoir une valeur faible et indépendante du gain, le facteur de bruit doit être faible et le point de compression doit être élevé.

Selon l'art antérieur, il est connu de réaliser les étages d'entrée de telles chaînes d'amplification à l'aide de la mise en parallèle de plusieurs amplificateurs de type émetteur commun que l'on commute selon le gain désiré. Il est alors nécessaire d'ajouter une résistance de faible valeur en parallèle sur l'entrée du circuit de façon que l'impédance d'entrée soit de faible valeur et indépendante du gain. Le document DE-A-1 487 527 concerne un amplificateur à gain variable.

Les performances en bruit se trouvent alors fortement dégradées.

L'invention ne présente pas cet inconvénient.

La présente invention a pour objet un amplificateur à gain variable constitué de n amplificateurs élémentaires en parallèle et comprenant des moyens permettant de sélectionner l'amplificateur élémentaire de rang j (j = 1, 2, ..., n) selon le gain désiré caractérisé en ce qu'il comprend des moyens permettant d'obtenir une impédance d'entrée de faible valeur et indépendante du gain de l'amplificateur sélectionné tout en préservant d'excellentes performances de bruit. Selon l'invention, l'amplificateur élémentaire de rang j est de type base commune.

D'autres caractéristiques et avantages de l'invention apparaîtront à la lecture d'un mode de réalisation préférentiel fait avec référence aux figures ci-annexées dans lesquelles :

- la figure 1 représente un étage d'entrée de chaîne d'amplification selon l'art antérieur,
- la figure 2 représente le schéma de principe d'un étage d'entrée de chaîne d'amplification selon l'invention,
- la figure 3 représente le schéma d'un étage d'entrée d'une chaîne d'amplification selon le mode de réalisation préférentiel de l'invention.

Sur toutes les figures, les mêmes repères désignent les mêmes éléments.

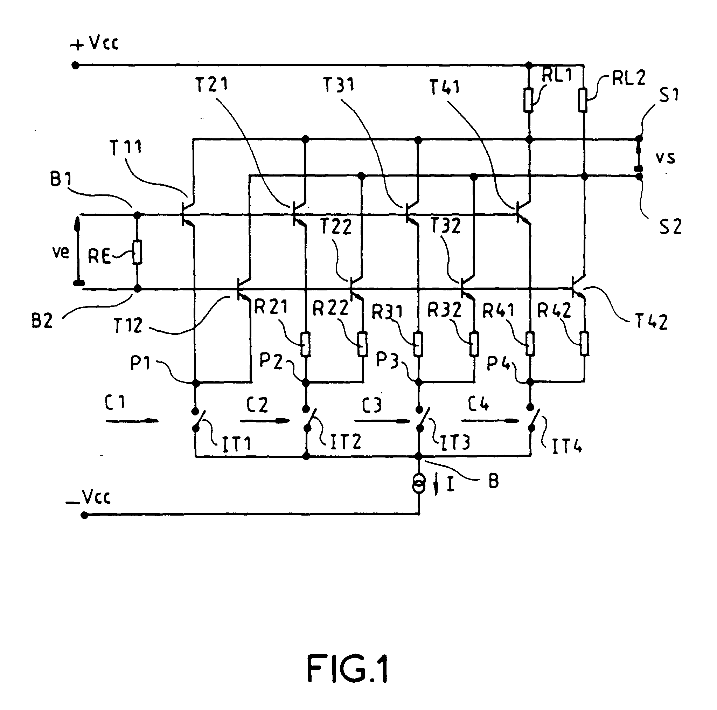

Le circuit de la figure 1 représente un exemple de réalisation d'un étage d'entrée de chaîne d'amplification selon l'art antérieur.

Ce circuit est constitué, à titre d'exemple, de quatre amplificateurs du type émetteur commun montés en parallèle. Chaque amplificateur est constitué de deux transistors Ti1 et Ti2 ( i = 1, 2, 3, 4). Les quatre transistors T11, T21, T31, et T41 ont leurs bases reliées au même point B1 et leurs collecteurs reliés au même point S1. Les quatre transistors T12, T22, T32 et T42 ont leurs bases reliées au même point B2 et leurs collecteurs reliés au même point S2.

Les résistances RL1 et RL2 relient la tension d'alimentation + Vcc aux points respectifs S1 et S2. L'émetteur de chaque transistor Ti1 est chargé par une résistance Ri1. De même, l'émetteur de chaque transistor Ti2 est chargé par une résistance Ri2. Comme cela est connu de l'homme de l'art, ces résistances d'émetteur permettent de linéariser la caractéristique de transfert de l'amplificateur.

Comme cela apparaît sur la figure 1, les résistances R11 et R12 sont égales à zéro. Les résistances Ri1 et Ri2 sont reliées à un même point Pi et chaque point Pi est relié au même point B par l'intermédiaire d'un interrupteur ITi. Un générateur de courant I relie la tension d'alimentation - Vcc au point B.

Chaque interrupteur ITi est commandé par une commande Ci. Selon que l'interrupteur ITi est fermé ou ouvert, l'amplificateur constitué des deux transistors Ti1 et Ti2 est respectivement activé ou désactivé.

La tension d'entrée ve est prise entre les points B1 et 82 et la tension de sortie vs entre les points S1 et S2. Comme cela a été mentionné précédemment une résistance RE est placée entre les points B1 et 82 afin que l'impédance d'entrée soit faible et indépendante du gain.

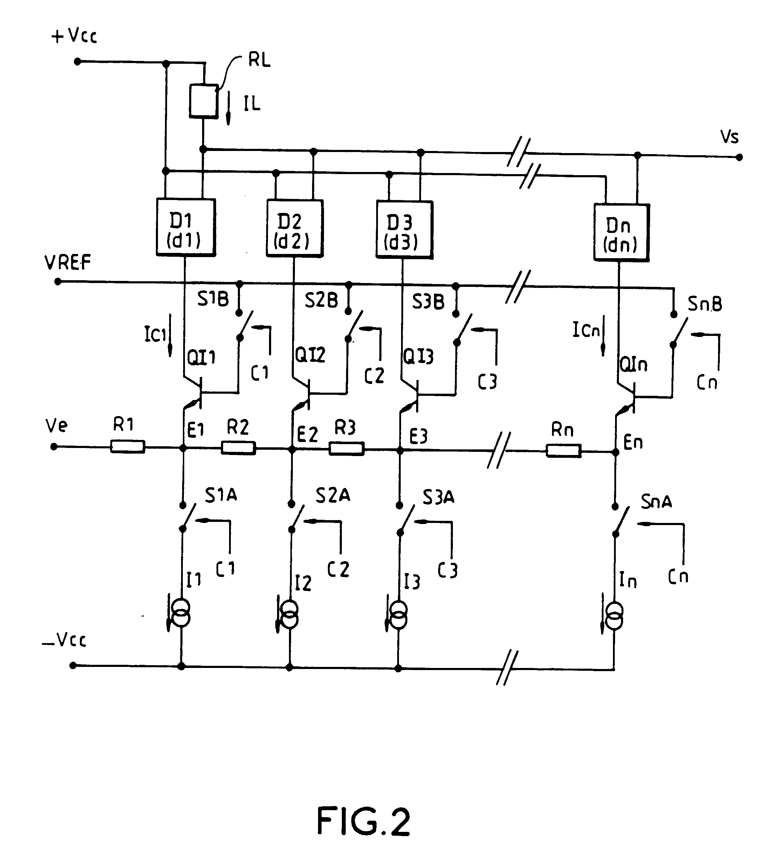

La figure 2 représente le schéma de principe d'un étage d'entrée de chaîne d'amplification selon l'invention.

Le circuit de la figure 2 est constitué de n amplificateurs élémentaires de type base commune montés en parallèle. Comme cela sera précisé ultérieurement, des moyens permettent de sélectionner un amplificateur de rang j quelconque de façon à obtenir le gain souhaité. Les transistors représentés sur la figure 2 sont de type NPN. Cependant, l'invention concerne aussi des circuits dont les transistors sont de type PNP. Il suffit alors de changer la polarité des alimentations.

L'amplificateur de rang j comprend principalement un transistor Qlj et un diviseur de courant Dj. Lorsque l'amplificateur de rang j est sélectionné, le transistor Qlj a sa base reliée à une tension continue VREF ajustée de façon que ledit transistor fonctionne dans une zone linéaire et son émetteur Ej relié à une tension continue de polarisation - Vcc par l'intermédiaire d'un générateur de courant Ij. Le diviseur de courant Dj, quant à lui, est relié au transistor Qlj de façon que seule une fraction dj du courant qui parcourt le transistor Qlj parcoure la résistance de charge RL reliée à la tension d'alimentation + Vcc et aux bornes de laquelle est prélevée la tension de sortie vs de l'étage d'amplification.

Les moyens permettant de sélectionner l'amplificateur de rang j sont constitués d'un interrupteur SjB reliant la base du transistor Qlj à la tension continue VREF et d'un interrupteur SjA reliant l'émetteur Ej du transistor Qlj au générateur de courant Ij. Préférentiellement, les interrupteurs SjA et SjB sont commandés par une même commande Cj.

Les émetteurs E1, E2,..., En des transistors respectifs Ql1, Ql2,...,Qln sont reliés entre eux par un ensemble de résistances montées en série.

Ainsi la résistance Rj relie-t-elle l'émetteur Ej-1 à l'émetteur Ej. L'émetteur E1 est relié, quant à lui, non seulement à l'émetteur E2 par la résistance R2 mais aussi à la tension variable d'entrée ve par l'intermédiaire d'une résistance R1.

Selon l'invention, quand l'amplificateur de rang j est sélectionné, l'impédance d'entrée de l'étage d'amplification vaut :

$$Zej = R1 + R2 + ... + Rj + Ut / Ij$$

où Ut est le potentiel thermodynamique (Ut = kT/q, k étant la constante de Boltzman, T la température du dispositif en degré absolu, et q la charge de l'électron).

Les valeurs des résistances R1, R2, ... , Rn et les valeurs des courants I1, I2, ..., In sont alors choisies de façon que l'impédance d'entrée de l'étage d'amplification ait la même valeur quel que soit l'amplificateur sélectionné.

Ainsi, quand le rang j croît, le courant continu Ij croît de façon à diminuer l'influence du terme Ut / Ij. La résistance R1 + R2 + .... + Rj compense alors la quantité Ut / Ij de façon que l'impédance d'entrée Zej reste constante.

Selon le mode de réalisation préférentiel, la résistance R1 est prise égale à zéro de façon que l'amplificateur de rang 1 présente de bonnes performances de bruit.

Comme cela a été mentionné précédemment, les diviseurs de courant permettent que seule une fraction dj du courant qui parcourt le transistor Qlj parcoure la résistance de charge RL aux bornes de laquelle est prélevée la tension de sortie- vs de l'étage d'amplification.

Ainsi, chaque diviseur de courant Dj est-il constitué de façon que le courant IL qui traverse la charge RL soit une fraction dj du courant Icj qui parcourt le transistor Qlj. On peut alors écrire :

$$IL = dj \times Icj$$

Le gain en tension de l'amplificateur de rang j est alors Avj tel que :

$$Avj = dj \times RL / Zej$$

De façon générale, le diviseur de courant Dj de l'amplificateur de rang j comprend un nombre quelconque de transistors et les fractions de courant dj sont ajustées de façon à assurer les valeurs désirées Avj. De façon préférentielle, le gain Avj décroît lorsque le rang j croît. Avantageusement, la série définie par les fractions d1, d2, ...., dn peut alors être une série à progression géométrique, par exemple de raison 1/2.

Il vient alors :

$$d1 = 1; d2 = \frac{1}{2}; ...; dn = \frac{1}{2^{n-1}}.$$

Le diviseur de rang j est alors constitué de $2^{(j-1)}$ transistors (non représentés sur la figure) dont les émetteurs sont reliés entre eux et au collecteur du transistor Qlj. Parmi ces $2^{(j-1)}$ transistors, $2^{(j-1)}-1$ ont leurs collecteurs reliés entre eux et à la même tension continue de polarisation + Vcc et le $2^{(j-1)\text{ème}}$ a son collecteur relié au point où est prélevée la tension de sortie vs de l'étage d'amplification, ce point étant lui-même relié, par l'intermédiaire de la résistance de charge RL, à la tension continue de polarisation + Vcc.

Les bases des $2^{(j-1)}$ transistors du diviseur de rang j sont reliées entre elles et à une même tension de polarisation. Préférentiellement, les bases de tous les transistors de tous les diviseurs Dj sont reliées au même point.

Avantageusement, l'amplificateur de rang 1 présente les meilleures performances de gain et de bruit. La variation de gain est assurée par les amplificateurs de rang supérieur à 1 qui présentent des gains de plus en plus faibles.

Préférentiellement, le courant continu qui parcourt la charge RL est choisi indépendant de la valeur du gain de l'amplificateur. Il s'en suit que le courant Ij est tel que Ij = I1 / dj.

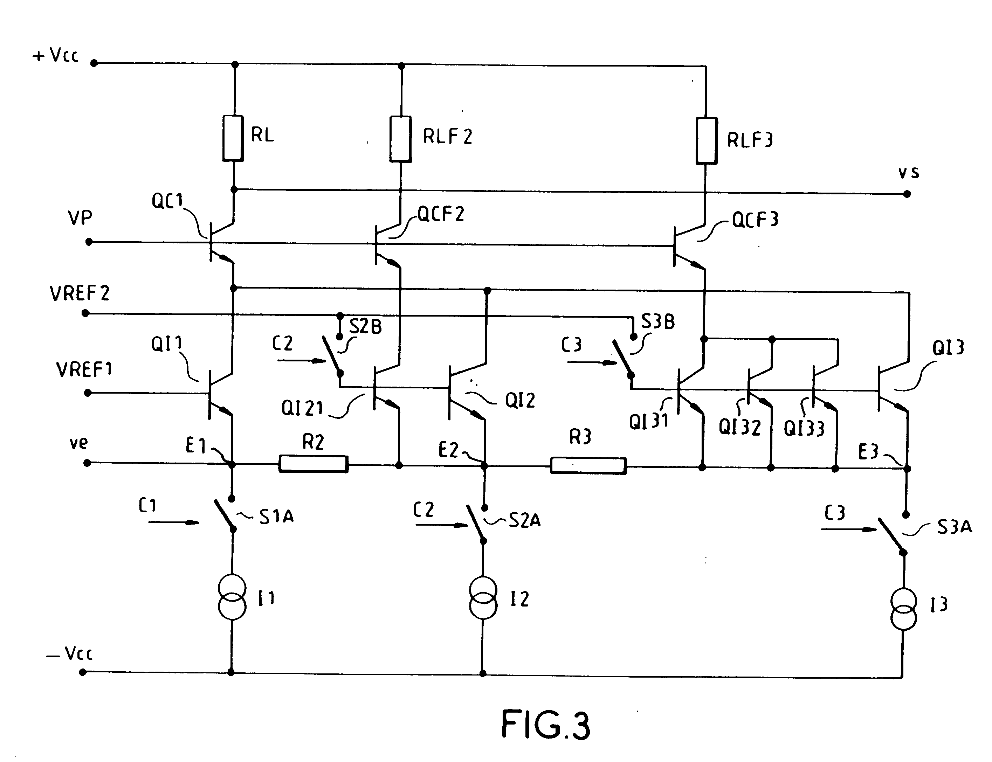

La figure 3 représente le schéma d'un étage d'entrée d'une chaîne d'amplification selon le mode de réalisation préférentiel de l'invention.

Sur ce schéma sont représentés trois amplificateurs montés en parallèle. De façon générale, le mode de réalisation préférentiel concerne cependant un nombre n quelconque d'amplificateurs en parallèle.

Selon le mode de réalisation préférentiel de l'invention chaque transistor Qlj de l'amplificateur de rang j participe au diviseur de courant Dj. Le collecteur de chaque transistor Qlj est relié à la charge RL par l'intermédiaire d'un même transistor QC1 monté en "cascode" de façon à améliorer la bande passante de l'étage d'amplification. Le transistor QC1 a son émetteur relié aux collecteurs des transistors Qlj, son collecteur relié à la sortie de l'étage d'amplification et à l'une des bornes de la charge RL dont l'autre borne est reliée à la tension d'alimentation + Vcc, et sa base reliée à une tension de polarisation VP ajustée de façon que le transistor QC1 fonctionne dans une zone linéaire.

Selon le mode de réalisation préférentiel, le diviseur de courant Dj comprend $2^{(j-1)}$ transistors. Ainsi, outre le transistor Qlj, le diviseur de courant de l'amplificateur de rang j comprend-il préférentiellement $2^{(j-1)}$-1 transistors Qljk, (k = 1, 2, $2^{(j-1)}$-1). Les transistors Qljk de même rang j ont leurs collecteurs reliés entre eux et à l'émetteur d'un transistor de type "cascode" QCFj dont la base est reliée à la tension de polarisation VP et dont le collecteur est relié à la tension de polarisation + Vcc par l'intermédiaire d'une résistance RLFj.

Les transistors QCFj permettent d'équilibrer les courants entre les transistors de division en équilibrant les tensions base-collecteur de ces derniers. Chaque résistance RLFj permet d'améliorer la précision avec laquelle est définie la tension base-émetteur du transistor QCFj.

Tous les transistors qui concourent à la constitution d'un même diviseur de rang j ont leurs bases reliées entre elles et leurs émetteurs reliés entre eux.

Comme précédemment, les émetteurs E1, E2 ..., En des transistors respectifs Ql1, Ql2, ... , Qln sont reliés entre eux par un ensemble de résistances montées en série. Il s'en suit que les émetteurs des transistors du diviseur de rang j sont reliés aux émetteurs des transistors du diviseur de rang j - 1 par une résistance Rj. L'émetteur El est relié, quant à lui, à la tension d'entrée ve. De même que dans le circuit de principe de la figure 2, un interrupteur SjA relie l'émetteur Ej du transistor Qlj à l'une des deux bornes d'un générateur de courant continu Ij dont l'autre borne est reliée à une tension de polarisation - Vcc.

Selon le mode de réalisation préférentiel, la base du transistor Ql1 de l'amplificateur de rang 1 est reliée directement à une première tension de référence VREF1, alors que les bases des transistors Qljk de même rang j supérieur à 1 sont reliées à une deuxième tension de référence VREF2 par l'intermédiaire d'un interrupteur SjB. Les tensions VREF1 et VERF2 sont choisies de façon que l'amplificateur de rang 1 soit bloqué lorsque l'un quelconque des amplificateurs de rang j supérieur à 1 est activé. Ainsi, pour une réalisation du circuit avec des transistors de type NPN, la tension VREF2 est-elle supérieure à la tension VREF1 et ajustée en conséquence. Du fait de l'absence d'interrupteur sur la base du transistor Ql1, les performances de bruit de l'amplificateur de rang 1 destiné à amplifier les signaux de faible amplitude se trouvent alors avantageusement améliorées par rapport aux performances des amplificateurs de rang supérieur à 1 destinés à amplifier des signaux moins sensibles au niveau de bruit.

Lorsque l'amplificateur de rang j est sélectionné, le transistor Qlj conduit ainsi que les $2^{(j-1)}$-1 transistors Qljk. De même que dans le circuit décrit en figure 2,. la résistance RL n'est parcourue que par une fraction dj du courant Ij. L'impédance d'entrée Zej et le gain Avj du transistor de rang j s'expriment comme suit :

$$Zej = R2 + R3 + .... + Rj + Ut / Ij,$$

$$Avj = dj \times RL / Zej.$$

De même que précédemment, les résistances R2, R3, ... , Rj et les courants I1, I2 ... , Ij sont choisis de façon que l'impédance d'entrée de l'étage d'amplification soit la même quel que soit le rang de l'amplificateur. Selon le mode de réalisation préférentiel, le courant Ij est choisi de façon que Ij = I1 / dj et la série définie par les fractions d1, d2, ..., dn est une série à progression géométrique, par exemple de raison 1/2. Comme précédemment, il vient alors :

$$d1 = 1; \ d2 = 1/2 \ ;...; \ dn = \frac{1}{2^{n-1}}$$

La valeur que prend la résistance RLFj est alors :

$$RLFj = RL / (2^{(j-1)}-1).$$

Si la dynamique du gain de l'étage d'amplification est élevée, il s'en suit que dj doit prendre des valeurs très faibles. La division du courant peut alors être réalisé en deux étapes et non plus directement par les $2^{(j-1)}$ transistors. La première étape peut être effectuée par la mise en parallèle de transistors de type "cascode" avec le transistor QCFj et la deuxième étape par la mise en parallèle de transistors Qljk en moins grand nombre que dans le cas précédent. L'invention concerne aussi ce type de configuration.

Les circuits décrits ci-dessus sont des circuits à mode référencé qui ne comportent qu'une entrée et qu'une sortie. Plus généralement, l'invention concerne des circuits à mode différentiel utilisant les circuits à mode référencé selon l'invention. De tels circuits sont alors des amplificateurs différentiels comportant deux entrées et deux sorties.

## Revendications

1. Amplificateur à gain variable constitué de n amplificateurs élémentaires en parallèle et comprenant des moyens (SjA, SjB) permettant de sélectionner un amplificateur élémentaire de rang j quelconque (j = 1, 2, ..., n) selon le gain désiré, caractérisé en ce que chaque amplificateur élémentaire de rang j est de type base commune et en ce qu'il comprend des moyens pour que l'impédance d'entrée de chaque amplificateur sélectionné ait la même valeur quel que soit l'amplificateur sélectionné, dans lequel chaque amplificateur élémentaire de rang j comprend un transistor Qlj qui a, lorsque ledit amplificateur est sélectionné, sa base reliée à une tension continue VREF ajustée de façon que ledit transistor fonctionne dans une zone linéaire et son émetteur (Ej) relié à une première tension continue de polarisation (- Vcc) par l'intermédiaire d'un générateur de courant Ij, l'émetteur du transistor de rang j + 1 étant relié à l'émetteur du transistor de rang j par une résistance Rj+1, l'émetteur E1 du transistor Ql1 étant relié non seulement à l'émetteur E2 du transistor Ql2 par la résistance R2 mais aussi à la tension variable d'entrée (ve), les valeurs des courants Ij et des résistances Rj étant choisies de façon que l'impédance d'entrée de l'amplificateur ait la même valeur quel que soit le rang j de l'amplificateur élémentaire, et un diviseur de courant (Dj) relié audit transistor Qlj de façon que seule une fraction dj du courant qui parcourt le transistor Qlj parcoure une résistance de charge (RL) aux bornes de laquelle est prélevée la tension de sortie (vs) de l'amplificateur.

2. Amplificateur selon la revendication 1, caractérisé en ce que le diviseur de courant (Dj) de rang j est constitué de $2^{(j-1)}$ transistors dont les émetteurs sont reliés entre eux et au collecteur du transistor Qlj, $2^{(j-1)}$-1 transistors ayant leurs collecteurs reliés entre eux et à une seconde tension continue de polarisation (+ Vcc), le $2^{(j-1)ème}$ transistor ayant son collecteur relié au point où est prélevée la tension de sortie (vs) dudit étage, ce point étant lui-même relié, par l'intermédiaire de la résistance de charge (RL), à la seconde tension continue de polarisation (+ Vcc).

3. Amplificateur selon l'une quelconque des revendications 1 ou 2 caractérisé en ce que les moyens (SjA, SjB) permettant de sélectionner un amplificateur élémentaire de rang j sont un interrupteur (SjB) reliant la base du transistor Qlj à la tension continue VREF et un interrupteur (SjA) reliant l'émetteur (Ej) du transistor Qlj au générateur de courant (Ij) de rang j.

4. Amplificateur selon la revendication 1, caractérisé en ce que chaque amplificateur de rang j comprend un transistor Qlj qui a, lorsque ledit amplificateur est sélectionné, sa base reliée à une tension continue (VREF1, VREF2) ajustée de façon que ledit transistor fonctionne dans une zone linéaire, son émetteur relié à une première tension continue de polarisation (- Vcc) par l'intermédiaire d'un générateur de courant, l'émetteur du transistor de rang j + 1 étant relié à l'émetteur du transistor de rang j par une résistance Rj+1, l'émetteur E1 du transistor Ql1 étant relié non seulement à l'émetteur E2 du transistor Q12 par la résistance R2 mais aussi à la tension variable d'entrée (ve), les valeurs des courants Ij et des résistances Rj étant choisies de façon que l'impédance d'entrée de l'amplificateur ait la même valeur quel que soit le rang j de l'amplificateur, et son collecteur relié à l'émetteur d'un transistor QC1 de type "cascode" dont la base est reliée à une tension continue VP ajustée de façon que le transistor QC1 fonctionne dans une zone linéaire et dont le collecteur est relié à une seconde tension continue de polarisation (+ Vcc) par l'intermédiaire d'une résistance de charge (RL) aux bornes de laquelle est prélevée la tension de sortie (vs) et en ce que chaque amplificateur de rang j supérieur à 1 comprend au moins un transistor Qljk dont l'émetteur est relié à l'émetteur du transistor Qlj, dont la base est reliée à une tension continue (VREF2) ajustée de façon que le transistor Qljk fonctionne dans une zone linéaire lorsque l'amplificateur de rang j est sélectionné, et dont le collecteur est relié à l'émetteur d'un transistor de type "cascode" (QCFj) dont la base est reliée à ladite tension VP et dont le collecteur est relié à la seconde tension continue de polarisation (+ Vcc) à travers une résistance RLFj.

5. Amplificateur selon la revendication 4, caractérisé en ce que l'amplificateur élémentaire de rang j comprend $2^{j-1}$-1 transistors Qljk (k = 1, 2, ..., $2^{j-1}$-1).

6. Amplificateur selon l'une quelconque des revendications 4 ou 5, caractérisé en ce que les moyens (SjA, SjB) permettant de sélectionner l'amplificateur élémentaire de rang 1 sont constitués d'un interrupteur (S1A) reliant l'émetteur de transistor Ql1 au générateur de courant de rang 1 (I1) et en ce que les moyens permettant de sélectionner l'amplificateur élémentaire de rang j supérieur à 1 sont constitués d'un interrupteur (SjB) reliant la base des transistors Qlj et Qljk à la tension continue VREF2 et d'un interrupteur (SjA) reliant l'émetteur du transistor Qlj au générateur de courant de rang j (Ij).

7. Amplificateur différentiel caractérisé en ce qu'il contient au moins un amplificateur selon l'une quelconque des revendications 1 à 6.

**Patentansprüche**

1. Verstärker mit variablem Verstärkungsgrad, bestehend aus n parallelgeschalteten Elementarverstärkern und aus Mitteln (SjA, SjB), mit denen je nach dem gewünschten Verstärkungsgrad ein beliebiger Elementarverstärker des Rangs j (j 0 1, 2 ..., n) ausgewählt werden kann, dadurch gekennzeichnet, daß jeder Elementarverstärker des Rangs j in Basisschaltung ausgeführt ist und Mittel enthält, die dafür sorgen, daß die Eingangsimpedanz jedes ausgewählten Verstärkers gleichen Wert hat, unabhängig von dem ausgewählten Verstärker, wobei jeder Elementarverstärker des Rangs j einen Transistor Qlj enthält, dessen Basis, wenn dieser Transistor ausgewählt ist, an eine solche Gleichspannung VREF angeschlossen ist, daß der Transistor in einem linearen Bereich arbeitet, während sein Emitter (Ej) dann an eine erste Gleichvorspannungsklemme (-Vcc) über einen Stromgenerator (Ij) angeschlossen ist, daß der Emitter des Transistors des Rangs j+1 an den Emitter der Transistors des Rangs j über einen Widerstand Rj+1 angeschlossen ist, daß der Emitter (El) des Transistors Ql1 nicht nur an den Emitter (E2) des Transistors Ql2 über den Widerstand R2, sondern auch an die variable Eingangsspannung (ve) angeschlossen ist, daß die Werte der Ströme Ij und der Widerstände Rj so gewählt sind, daß die Eingangsimpedanz des Verstärkers den gleichen Wert für alle Elementarverstärkerränge j besitzt und daß ein Stromteiler (Dj) an den Transistor Qlj so angeschlossen ist, daß nur ein Bruchteil dj des den Transistor Qlj durchfließenden Stroms durch einen Lastwiderstand (RL) fließt, an dessen Klemmen die Ausgangsspannung (vs) des Verstärkers abgenommen wird.

2.  Verstärker nach Anspruch 1, dadurch gekennzeichnet, daß der Stromteiler (Dj) des Rangs j aus $2^{j-1}$ Transistoren besteht, deren Emitter miteinander verbunden und an den Kollektor des Transistors Qlj angeschlossen ist, daß die Kollektoren von $2^{j-1}-1$ Transistoren miteinander verbunden und an eine zweite Vorspannungsklemme (+Vcc) angeschlossen sind, daß der Kollektor des $2^{j-1}$-ten Transistors an einen Punkt angeschlossen ist, an dem die Ausgangsspannung (vs) der Stufe abgenommen wird, und daß dieser Punkt seinerseits über den Lastwiderstand (RL) an die zweite Gleichvorspannungsklemme (+Vcc) angeschlossen ist.

3.  Verstärker nach einem beliebigen der Ansprüche 1 oder 2, dadurch gekennzeichnet, daß die Mittel (SjA, SjB), mit denen ein Elementarverstärker des Rangs j ausgewählt werden kann, von einem Schalter (SjB), der die Basis des Transistors Qlj an die Gleichspannung VREF anschließt, und von einem Schalter (SjA) gebildet werden, der den Emitter (Ej) des Transistors Qlj an den Stromgenerator (Ij) des Rangs j anschließt.

4.  Verstärker nach Anspruch 1, dadurch gekennzeichnet, daß jeder Verstärker des Rangs j einen Transistor Qlj enthält, dessen Basis, wenn dieser Transistor ausgewählt ist, an eine solche Gleichspannung (VREF1, VREF2) angeschlossen ist, daß der Transistor in einem linearen Bereich arbeitet, während sein Emitter (Ej) an eine erste Gleichvorspannungsklemme (-Vcc) über einen Stromgenerator angeschlossen ist, daß der Emitter des Transistors des Rangs j+1 an den Emitter der Transistors des Rangs j über einen Widerstand Rj+1 angeschlossen ist, daß der Emitter (E1) des Transistors Ql1 nicht nur an den Emitter (E2) des Transistors Ql2 über den Widerstand R2, sondern auch an die variable Eingangsspannung (ve) angeschlossen ist, daß die Werte der Ströme Ij und der Widerstände Rj so gewählt sind, daß die Eingangsimpedanz des Verstärkers den gleichen Wert für alle Elementarverstärkerränge j besitzt, während der Kollektor des Transistors Ql1 mit dem Emitter eines Transistors QC1 vom Kaskodentyp verbunden ist, dessen Basis an einer solchen Gleichspannung (VP) liegt, daß der Transistor QC1 in einem linearen Bereich arbeitet, und dessen Kollektor an einer zweiten Gleichvorspannungsklemme (+Vcc) über einen Lastwiderstand (RL) liegt, an dessen Klemmen die Ausgangsspannung (vs) abgenommen wird, und daß jeder Verstärker des Rangs j>1 mindestens einen Transistor Qljk enthält, dessen Emitter an den Emitter des Transistors Qlj, dessen Basis an eine solche Gleichspannung (VREF2), daß der Transistor Qljk in einem linearen Bereich arbeitet, wenn der Verstärker des Rangs j ausgewählt ist, und dessen Kollektor an den Emitter eines Transistors (QCFj) vom Kaskodentyp angeschlossen ist, dessen Basis an der Spannung VP liegt und dessen Kollektor mit der zweiten Gleichvorspannungsklemme (+Vcc) über einen Widerstand (RLFj) verbunden ist.

5.  Verstärker nach Anspruch 4, dadurch gekennzeichnet, daß der Elementarverstärker des Rangs j $2^{j-1}-1$ Transistoren Qljk enthält (k = 1, 2,..., $2^{j-1}-1$).

6.  Verstärker nach einem beliebigen der Ansprüche 4 oder 5, dadurch gekennzeichnet, daß die Mittel (SjA, SjB), mit denen der Elementarverstärker des Rangs 1 ausgewählt werden kann, von einem Schalter (S1A) gebildet werden, der den Emitter des Transistors Ql1 mit dem Stromgenerator (I1) des Rangs 1 verbindet, und daß die Mittel, mit denen der Elementarverstärker eines Rangs j>1 ausgewählt wird, von einem Schalter (SjB), der die Basis der Transistoren Qlj und Qljk mit der Gleichspannung VREF2 verbindet, und von einem Schalter (SjA) gebildet werden, der den Emitter des Transistors Qlj mit dem Stromgenerator (Ij) des Rangs j verbindet.

7.  Differentialverstärker, dadurch gekennzeichnet, daß er mindestens einen Verstärker nach einem beliebigen der Ansprüche 1 bis 6 enthält.

**Claims**

1.  Variable-gain amplifier consisting of n elementary amplifiers in parallel and comprising means (SjA, SjB) for selecting an elementary amplifier of arbitrary rank j (j = 1, 2, ..., n) depending on the desired gain, characterized in that each elementary amplifier of rank j is of common-base type, and in that it comprises means so that the input impedance of each selected amplifier has the same value, irrespective of the selected amplifier, in which each elementary amplifier of rank j comprises a transistor Qlj which, when the said amplifier is selected, has its base connected to a DC voltage VREF which is adjusted in such a way that the said transistor operates in a linear region, and has its emitter (Ej) connected to a first bias DC voltage (- Vcc) by means of a current generator Ij, the emitter of the transistor of rank j + 1 being connected to the emitter of the transistor of rank j via a resistor Rj, the emitter El of the transistor Ql1 being connected not only to the emitter E2 of the transistor Ql2 via the resistor R2 but also to the variable input voltage (ve), the values of the currents Ij and of the resistances Rj being chosen in such way that the input impedance of the amplifier has the same value, irrespective of the rank j of the elementary amplifier, and a current divider (Dj) connected to the said transistor (Qlj) in such a way that only a fraction dj of the current flowing through the transistor Qlj flows through a load resistor (RL), across the terminals of which the output voltage (vs) of the amplifier is tapped.

2. Amplifier according to Claim 1, characterized in that the current divider (Dj) of rank j consists of $2^{(J-1)}$ transistors whose emitters are connected to one another and to the collector of the transistor Qlj, $2^{(J-1)}$-1 transistors having their collectors connected to one another and to a second bias DC voltage (+ Vcc), the $2^{(J-1)th}$ transistor having its collector connected to the point from which the output voltage (vs) of the said stage is tapped, this point being itself connected, by means of the load resistor (RL) to the second bias DC voltage (+ Vcc).

3. Amplifier according to either one of Claims 1 and 2, characterized in that the means (SjA, SjB) for selecting an elementary amplifier of rank j are a switch (SjA) connecting the base of the transistor Qlj to the DC voltage VREF and a switch (SjA) connecting the emitter (Ej) of the transistor Qlj to the current generator (Ij) of rank j.

4. Amplifier according to Claim 1, characterized in that each amplifier of rank j comprises a transistor Qlj which, when the said amplifier is selected, has its base connected to a DC voltage (VREF1, VREF2) which is adjusted in such a way that the said transistor operates in a linear region, has its emitter connected to a first bias DC voltage (- Vcc) by means of a current generator, the emitter of the transistor of rank j + 1 being connected to the emitter of the transistor of rank j via a resistor Rj, the emitter El of the transistor Ql1 being connected not only to the emitter E2 of the transistor Ql2 via the resistor R2 but also to the variable input voltage (ve), the values of the currents Ij and of the resistances Rj being chosen in such a way that the input impedance of the amplifier has the same value irrespective of the rank j of the amplifier, and its collector connected to the emitter of a transistor QC1 of the "cascode" type, the base of which is connected to a DC voltage VP which is adjusted in such a way that the transistor QC1 operates in a linear region and the collector of which is connected to a second bias DC voltage (+ Vcc) by means of a load resistor (RL), across the terminals of which the output voltage (vs) is tapped, and in that each amplifier of rank j greater than 1 comprises at least one transistor Qljk whose emitter is connected to the emitter of the transistor Qlj, whose base is connected to a DC voltage (VREF2) which is adjusted in such a way that the transistor Qljk operates in a linear region when the amplifier of rank j is selected, and whose collector is connected to the emitter of a transistor of the "cascode" type (QCFj) whose base is connected to the said voltage VP and whose collector is connected to the second bias DC voltage (+ Vcc) through a resistor RLFj.

5. Amplifier according to Claim 4, characterized in that the elementary amplifier of rank j comprises $2^{J-1}$-1 transistors Qljk (k = 1, 2, ..., $2^{j-1}$-1).

6. Amplifier according to any one of Claims 4 or 5, characterized in that the means (SjA, SjB) for selecting the elementary amplifier of rank 1 consist of a switch (S1A) connecting the emitter of the transistor Ql1 to the current generator of rank 1 (I1), and in that the means for selecting the elementary amplifier of rank j greater than 1 consist of a switch (SjB) connecting the base of the transistors Qlj and Qljk to the DC voltage VREF2 and a switch (SjA) connecting the emitter of the transistor Qlj to the current generator of rank j (Ij).

7. Differential amplifier characterized in that it contains at least one amplifier according to any one of Claims 1 to 6.

FIG.1

FIG.2

FIG.3

EP 0 658 977 B1